# EUROPEAN PATENT APPLICATION

(11) **EP 0 834 915 A1**
(43) Date of publication of application: **08.04.1998**
(21) Application number: 97116381.1
(22) Date of filing: 19.09.1997
(51) Int. Cl.: H01L 21/768

(54) **Fabrication method of multi-layered wiring**

(30) Priority: 27.09.1996 JP 256913/96
(71) Applicant: NEC Corporation, Minato-ku, Tokyo 108-01 (JP)
(72) Inventor: Kobayashi, Takaaki, c/o NEC Corporation, Tokyo 108-01 (JP)
(74) Representative: von Samson-Himmelstjerna, Friedrich R., Dipl.-Phys.

(57) **Abstract**

According to the method, on a first insulating film (2) formed on a semiconductor substrate (1), a first aluminum film (3), a tungsten film (4) and a second insulating film (5) are formed successively. Then, a second insulating film pattern (5a) is formed by etching away unnecessary portion of the second insulating film using a first resist pattern (6) as a mask. Then, a second resist pattern (7) is formed in a region including the second insulating film pattern (5a) and unnecessary portions of the tungsten film (4) and the aluminum film (3) are etched away. Then, the connecting posts (4b) are formed by etching away the tungsten pattern (4a) on the first aluminum wiring pattern (3a) by using the second insulating pattern (5a) as a mask. Then, a third insulating film (8) is formed to a thickness larger than the height of the connecting posts (4b) and, then, the third insulating film (8) is polished to flatten its surface and to expose upper surfaces of the connecting posts (4b). Thereafter, the upper layer wiring is formed thereon.

## Description

### BACKGROUND OF THE INVENTION

The present invention relates to a fabrication method of a semiconductor device and, particularly, to a fabrication method of a multi-layered wiring thereof.

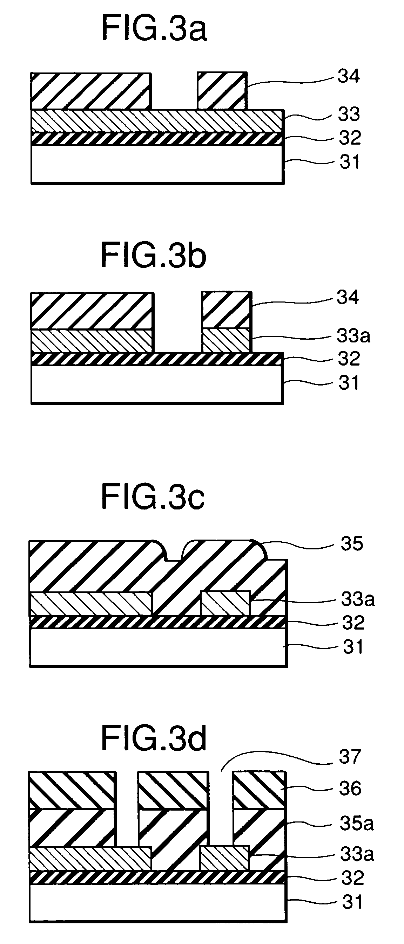

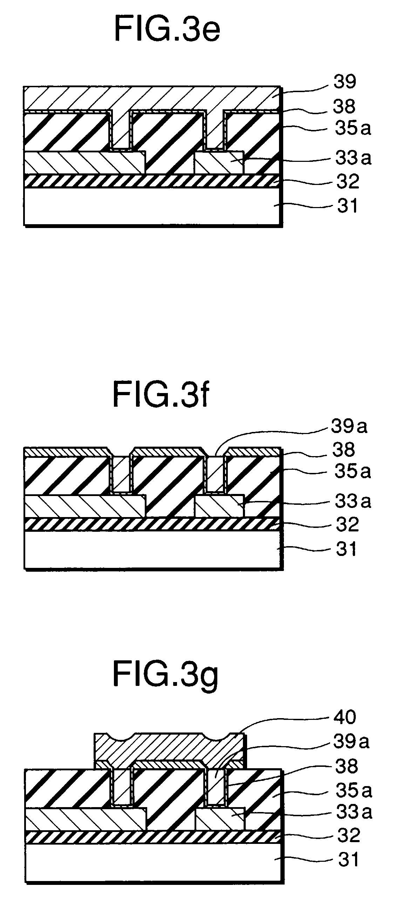

Figs. 3(a) to 3(g) show an example of a conventional fabrication method of a multi-layered wiring for a semiconductor device. As shown in Fig. 3(a), on a first insulating film 32 formed on a surface of a semiconductor substrate 31, a first aluminum film 33 is formed. A photo resist film is formed on the first aluminum film 33 and is patterned by usual photolithography to form a first resist pattern 34. Then, as shown in Fig. 3(b), the first aluminum film 33 is etched by usual dry etching with using the first resist pattern 34 as a mask, resulting in a first aluminum wiring pattern 33a. After the first resist pattern 34 is removed, a second insulating film 35 is formed as shown in Fig. 3(c). Thereafter, as shown in Fig. 3(d), a surface of the second insulating film 35 is flattened by chemical and mechanical polishing, the second insulating film 35 is patterned by using a second resist pattern 36 formed thereon by usual photolithography as a mask to open connection holes 37 for electrically connecting an upper and lower wiring layers. Thereafter, as shown in Fig. 3(e), a barrier film 38 is formed and then a tungsten film 39 is formed on the whole surface of the wafer by CVD. Thereafter, as shown in Fig. 3(f), the whole surface is etched back by usual etching to remove the tungsten film 39 except that on the connection holes 37, resulting in connection posts 39a. Thereafter, as shown in Fig. 3(g), a second aluminum wiring pattern 40 is formed in the similar manner to the first aluminum wiring pattern 33a.

In the conventional method mentioned above in which the connection holes are opened after the first layer wiring is formed, however, it is necessary, in order to maintain a sufficient reliability of the multi-layered wiring structure, to provide a large area in the semiconductor substrate for the first layer wiring pattern, in which the connection holes are to be opened, by taking the positional alignment accuracy into consideration, which fact is one of main obstacles in miniaturizing the semiconductor device. Further, in order to have an enough connection yield, dry-etching for opening the connection holes must be performed excessively to prevent second insulating film material from being left unetched. Since such excess etching may leave a large amount of reaction product on inner walls of the connection holes, a special step is necessary as a post processing for removing such reaction product, which is a main obstacle for reducing the fabrication term. Moreover, since the tungsten film may not completely cover the inner walls of the connection holes, voids may be produced in forming the connection posts which make the connecting resistance large. Further, since the tungsten film in the connection holes may be over etched and recessed during the etching-back process for removing the tungsten film on the surface of the wafer, the covering ability of the tungsten film in the over-etched and recessed portions is substantially degraded and, therefore, it becomes impossible to form the upper layer connection holes in alignment with the portions. Due to the defects mentioned above, adaptation for miniaturization of the semiconductor device is substantially difficult.

In order to solve these defects, Japanese Patent Application Laid-open No. H5-102149 proposes a fabrication method which is shown in Figs. 4(a) to 4(g).

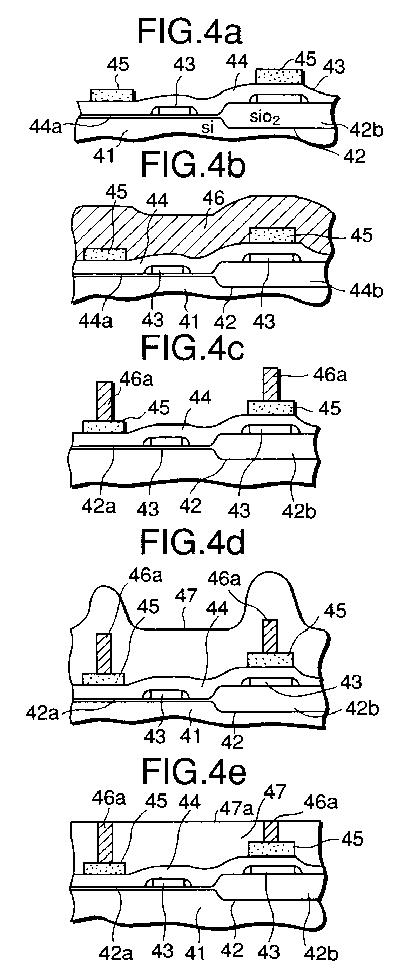

As shown in Fig. 4(a), a surface of a semiconductor substrate 41 is oxidized to form an oxide film 42 whose thickness is made locally different to provide an active region and an element separating region by utilizing the difference in film thickness of the oxide film 42. A gate electrode 43 of polysilicon having a predetermined pattern is formed on the oxide film 42 and an under layer insulating film 44 is formed on the whole surface of the gate electrode 43.

When a multi-layered wiring is to be formed on the under layer insulating film 44, a first aluminum film 45 is provided on the under layer insulating film 44 for forming a first layer wiring pattern and then the first aluminum film 45 is patterned by photolithography.

Thereafter, as shown in Fig. 4(b), a tungsten film 46 is formed on the wafer. Then, as shown in Fig. 4(c), the tungsten film 46 is patterned by photolithography to form wiring connection posts 46a. Thereafter, an inter-layer insulating film 47 is formed on the wafer as shown in Fig. 4(d).

A surface of the wafer on the side of the inter-layer insulating film 47 is polished to flatten the surface of the inter-layer insulating film 47 as well as to expose upper portions of the wiring connection posts 46a, as shown in Fig. 4(e).

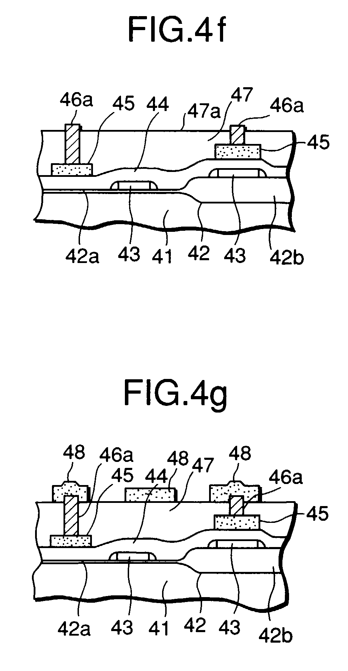

Thereafter, as shown in Fig. 4(f), the inter-layer insulating film 47 is etched such that the posts 46a protrude equally from the inter-layer insulating film 47 while the aluminum film 45 is not exposed. Thereafter, a pattern of a second aluminum film 48 is provided on the wafer for an upper layer wiring as shown in Fig. 4(g).

Therefore, according to this fabrication method, the posts 46a having the upper portions protruded equally from the inter-layer insulating film 47 are electrically connected to the second aluminum film 48 reliably to thereby electrically connect the lower layer wiring 45 to the upper layer wiring 48 reliably.

In this fabrication method, however, since the tungsten film is formed after the first layer wiring pattern is formed, some surface irregularity of the tungsten film occurs correspondingly to film thickness of the first layer wiring with which it becomes very difficult to obtain a desired pattern in photolithography for forming the connection holes. Further, in etching the tungsten film, some of the film tends to be left on the side wall portion of the first layer wiring.

In order to completely remove such residual tungsten on the side wall of the first layer wiring, the etching must be performed excessively. Therefore, the control of the etching process becomes very difficult. Particularly, when a gap between wiring lines is very narrow, the removal of the tungsten film in the gap becomes impossible, resulting in a substantial reduction of yield.

### SUMMARY OF THE INVENTION

The present invention was made in order to solve the problems of the conventional fabrication method and an object of the present invention is to provide a fabrication method of a semiconductor device, which is particularly effective for a miniaturization of a wiring and is capable of forming a multi-layered wiring simply and stably with high reliability.

In order to achieve the above object, the fabrication method of the semiconductor device, according to the present invention, is featured by comprising the steps of forming a first electrically conductive film on an under-layer insulating film formed on a surface of a semiconductor substrate, forming a second electrically conductive film on the first electrically conductive film, forming a first insulating film on the second electrically conductive film, patterning the first insulating film in regions thereof in which posts for electrically connecting an upper wiring layer to a lower wiring layer are to be formed, by means of photolithography, forming a first pattern of laminated wiring by etching the second and first electrically conductive films continuously by means of photolithography, forming the posts for electrically connecting the lower wiring layer composed of the first electrically conductive film and the upper wiring layer composed of the second electrically conductive film by etching away the second electrically conducive film of the laminated wiring pattern with using the first insulating film pattern as a mask, forming a second insulating layer to a thickness larger than a height of the posts, flattening the second insulating film and exposing surfaces of the posts by chemically and mechanically polishing a surface of the second insulating film, forming a third electrically conductive film and forming a second wiring pattern by etching the third electrically conductive film by photolithography.

According to the present invention, the laminated wiring is formed by etching the electrically conductive films which become the connecting posts while patterning the electrically conductive film which becomes the lower wiring layer and, thereafter, connecting holes are formed by partially removing the laminated wiring. Therefore, it is possible to form the connecting posts regardless of a gap between wiring lines. Further, there is no residuary material of the connecting posts in the gap even when the gap is very narrow and thus it is possible to obtain a stable yield.

### BRIEF DESCRIPTION OF THE DRAWINGS

Figs. 1(a) to 1(g) are cross sectional views of a semiconductor device showing fabrication steps according to a first embodiment of the present invention;
Figs. 2(a) to 2(e) are cross sectional views of a semiconductor device showing fabrication steps according to a second embodiment of the present invention;
Figs. 3(a) to 3(g) are cross sectional views of a semiconductor device showing a conventional fabrication method; and
Figs. 4(a) to 4(g) are cross sectional views of a semiconductor device showing another conventional fabrication method.

### DETAILED DESCRIPTION OF THE PREFERRED EMBODIMENTS

### [First Embodiment]

A fabrication method of a semiconductor device according to a first embodiment of the present invention will be described in detail with reference to Figs. 1(a) to 1(g).

As shown in Fig. 1(a), a first insulating film 2 for separating an underlying element forming layer from upper wiring layers is formed on a whole surface of a semiconductor substrate 1. For simplicity of illustration, elements and an element separating pattern formed in the surface of the semiconductor substrate and steps of the surface resulting from the formation of the elements, etc., are omitted in the drawings.

When a multi-layered wiring is to be formed, a first aluminum film 3 containing aluminum as main constituent is formed on the first insulating film 2 to a thickness of, for example, 0.5 microns and a tungsten film 4 is formed continuously on the first aluminum film 3 to a thickness of, for example, 1.0 micron. Thereafter, a second insulating film 5 containing silicon oxide as main constituent is formed on the tungsten film 4 to a thickness of, for example, 0.2 microns.

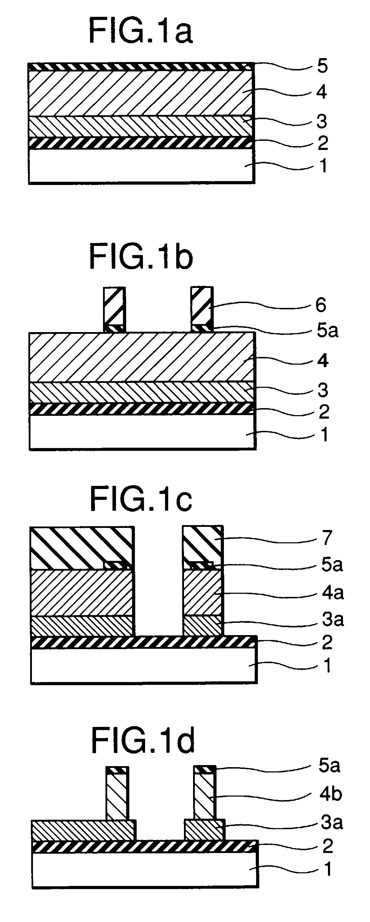

Then, as shown in Fig. 1(b), a first resist pattern 6 is formed on only a region of the second insulating film 5, in which connecting posts for electrically connecting an upper layer wiring to a lower layer wiring by using usual photolithography. Thereafter, a portion of the second insulating film 5 which is unnecessary is etched away by usual dry-etching with using the first resist pattern 6 as a mask and the tungsten film 4 as a stopper to form a second insulating film pattern 5a.

Then, as shown in Fig. 1(c), the first resist pattern 6 is removed and, instead thereof, a second resist pattern 7 is formed in only a region in which the lower layer wiring is to be formed, by usual photolithography again. Then, unnecessary portions of the tungsten film 4 and the first aluminum film 3 are removed by usual dry-etching with using the second resist pattern 7 as a mask, resulting in a laminated wiring composed of the tungsten pattern 4a and the first aluminum wiring pattern 3a.

Then, as shown in Fig. 1(d), the second resist pattern 7 is removed and only unnecessary portion of the tungsten pattern 4a is etched away by usual dry-etching with using the second insulating film pattern 5a as a mask, resulting in connecting posts 4b for connecting the upper layer wiring to the lower layer wiring. The selective removal of the unnecessary portion of the tungsten pattern 4a can be realized by dry-etching using a mixture gas containing SF6 which has a high selectivity with respect to silicon oxide film and aluminum. Further, although not shown, it is possible to stop the dry-etching before the tungsten pattern is completely removed and to use the residuary tungsten pattern as a first wiring layer of the laminated wiring which includes the first aluminum wiring pattern 3a.

Then, as shown in Fig. 1(e), a third insulating film 8 is formed by forming an inter-layer insulating film of mainly a silicon oxide film to a thickness larger than the thickness of the second insulating film pattern 5a or the height of the connecting posts 4b. Although, in this embodiment, the insulating films are formed by usual plasma CVD, it is, of course, possible to obtain a similar effect to that obtained by plasma CVD, by using insulating films formed by sputtering.

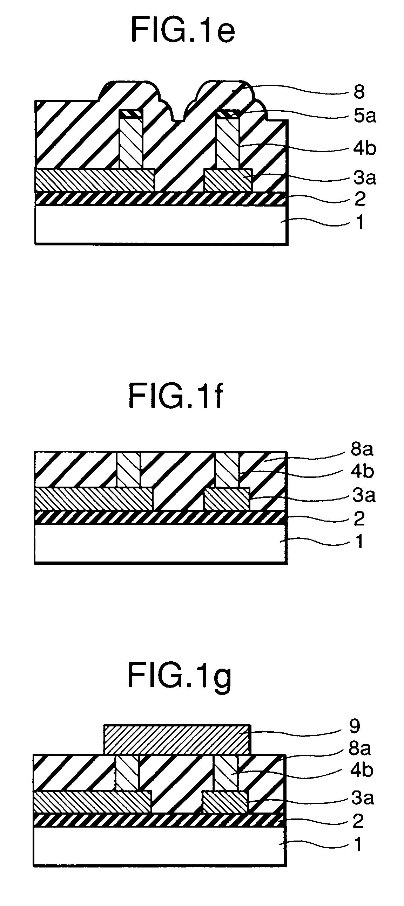

Then, as shown in Fig. 1(f), a surface of the third insulating film 8 is chemically and mechanically polished to remove steps thereof to thereby smooth the surface and to remove the third insulating film 8 on the connecting posts 4b to thereby expose the posts, resulting in a flattened third insulating film 8a.

Although, in this embodiment, the flattening of the third insulating film is achieved by chemical and mechanical polishing, a similar effect can be obtained by etching back the third insulating film by usual etching. Further, it is possible to make the connection between the connecting posts 4b and the upper layer wiring more reliable by slightly etching the whole flattened surface of the third insulating film 8a by dry etching or wet etching to remove an oxide film formed on the connecting posts 4b and a surface portion of the flattened third insulating film 8a such that the connecting posts 4b protrude slightly from a surface of the third insulating film 8a.

Then, as shown in Fig. 1(g), a second aluminum film containing aluminum mainly is formed on the flattened third insulating film 8a to a thickness of, for example, 0.5 microns like the first wiring layer to form a third resist pattern (not sown) in only a region of the wafer in which the upper layer wiring pattern including the connecting posts 4b is to be formed by usual photolithography and, then, a portion of the second aluminum film which is unnecessary is etched away by usual dry etching with using the third resist pattern as a mask, resulting in a second aluminum wiring pattern 9.

In this embodiment, the formation of a 2-layer wiring is described. When a multi-layer wiring including three or more wiring layers is to be formed, the second and subsequent wiring layers are formed by laminating tungsten films similarly to the first wiring layer. Therefore, according to the present invention, the connection between the upper layer wiring and the lower layer wiring, which is very difficult with reduction of the size of semiconductor device, can be achieved easily with high reliability. Further, although, in the described embodiment, the electrically conductive films formed of aluminum mainly are used, such conductive films may be formed of other material containing copper or tungsten as main constituent. Further, the laminated wiring structure may include a barrier film of titanium. Further, although the connecting posts are formed of tungsten, it is, of course, possible to form the connecting posts by using other material containing aluminum or copper as main constituent, with similar effect.

### [Second Embodiment]

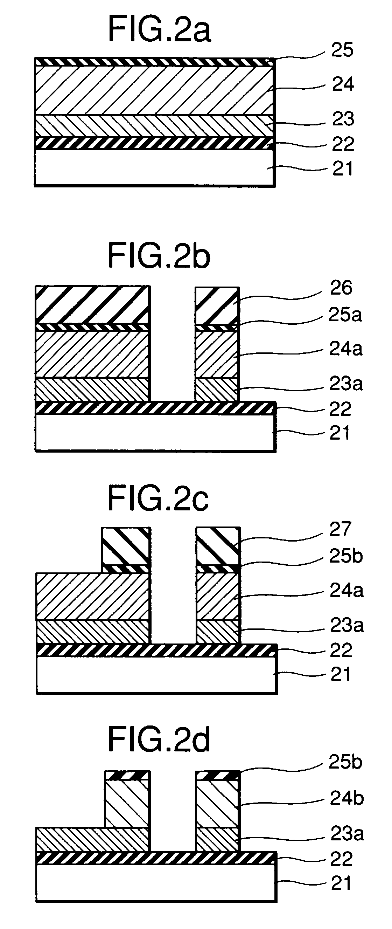

A second embodiment of the present invention will be described with reference to Figs. 2(a) to 2(e).

As shown in Fig. 2(a), a first insulating film 22 which is an insulating film insulating an underlying element forming layer from upper wiring layers is formed on a whole surface of a semiconductor substrate 21, as in the first embodiment. For simplicity of illustration, elements and an element separating pattern formed in the semiconductor substrate and steps of a surface of the semiconductor substrate which result from the formation of the element, etc., are omitted in these figures.

When a multi-layered wiring is to be formed, a first aluminum film 23 containing mainly aluminum is formed on the first insulating film 22 to a thickness of, for example, 0.5 microns and a tungsten film 24 is formed continuously on the first aluminum film 23 to a thickness of, for example, 1.0 micron. Thereafter, a second insulating film 25 containing mainly silicon oxide is formed on the tungsten film 24 to a thickness of, for example, 0.2 microns.

Then, as shown in Fig. 2(b), a first resist pattern 26 is formed on only a region of the second insulating film 25 in which connecting posts for electrically connecting an upper wiring layer to a lower wiring layer by using usual photolithography. Thereafter, portions of the second insulating film 25, the tungsten film 24 and the first aluminum film 23 which are unnecessary are etched away by usual dry-etching with using the first resist pattern 26 as a mask, resulting in a second insulating film pattern 25a, a tungsten pattern 24a and a first aluminum wiring pattern 23a.

Then, as shown in Fig. 2(c), the first resist pattern 26 is removed and, thereafter, a second resist pattern 27 is formed in only a region in which connecting posts for electrically connecting an upper layer wiring to a lower layer wiring are to be formed is formed on the second insulating film 25a by usual photolithography again. Then, an unnecessary portion of the second insulating film pattern 25a is removed by usual dry-etching with using the second resist pattern 27 as a mask and the tungsten pattern 24a as a stopper, to form a second insulating film pattern 25b.

Since it is enough for the second resist pattern 27 to cover the region in which the connecting posts are to be formed, there is a merit that the photolithography can be performed relatively easier compared with the first embodiment.

Then, as shown in Fig. 2(d), after the second resist pattern 27 is removed, only unnecessary portion of the tungsten pattern 24a is etched away by usual dry-etching with using the second insulating film pattern 25b as a mask, resulting in the connecting posts 24b for connecting the upper wiring layer to the lower wiring layer.

The selective removal of the unnecessary portion of the tungsten film can be realized by using a mixture gas containing SF6 which has a high selectivity with respect to silicon oxide film and aluminum.

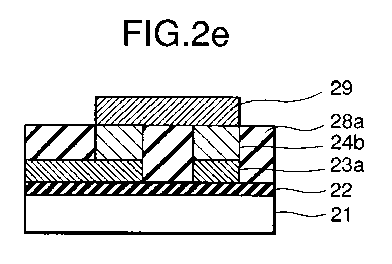

Then, after a third insulating film is formed, a second aluminum wiring pattern 29 is formed as the upper layer wiring by chemically and mechanically polishing a surface of the third insulating film to flatten it and to expose upper surfaces of the connecting posts 24b, as shown in Fig. 2(e), similarly to the first embodiment.

As described hereinbefore, since, according to the fabrication method of semiconductor device of the present invention, the connecting holes are formed by forming the laminated wiring layers by forming the electrically conductive film for forming the connecting posts simultaneously with the patterning of the electrically conductive film as the lower layer wiring, and, then, removing a portion of the upper layer wiring of the laminated wiring layers, it is possible to form the connecting posts regardless of the wiring gap, there is no residuary material of the connecting posts in the gap even when the gap is very narrow and thus it is possible to obtain a stable yield.

## Claims

1. A semiconductor device fabrication method comprising the steps of:
forming a first electrically conductive film (3) on an under-layer insulating film (2) formed on a surface of a semiconductor substrate (1);
forming a second electrically conductive film (4) on said first electrically conductive film (3);
forming a first insulating film (5) on said second electrically conductive film (4);
patterning said first insulating film (5) in regions thereof in which posts (4b) for electrically connecting an upper wiring layer to a lower wiring layer are to be formed, by means of photolithography;
forming a first pattern of laminated wiring by etching said second and first electrically conductive films (4; 3) continuously by means of photolithography;
forming said posts (4b) for electrically connecting said lower wiring layer composed of said first electrically conductive film (3) and said upper wiring layer composed of said second electrically conductive film (4) by etching away said second electrically conductive film (4) of said laminated wiring pattern with using said first insulating film pattern (5a) as a mask;
forming a second insulating layer (8) to a thickness larger than a height of said posts (4b);
flattening said second insulating film (8) and exposing surfaces of said posts (4b) by chemically and mechanically polishing a surface of said second insulating film (8);
forming a third electrically conductive film; and
forming a second wiring pattern (9) by etching said third electrically conductive film by photolithography.

2. A semiconductor device fabrication method as claimed in claim 1, further comprising the step of, after said first lamination layer wiring pattern is formed by continuously etching said first insulating film (5), forming said first insulating film pattern (5a) in a region in which said posts (4b) for electrically connecting said upper wiring layer to said lower wiring layer are to be formed, by using photolithography again.

3. A semiconductor device fabrication method as claimed in claim 1, wherein said first and second electrically conductive films (3; 4) are formed of the same material simultaneously.

4. A semiconductor device fabrication method comprising the steps of:
forming a first electrically conductive film (3) on an under-layer insulating film (2) formed on a surface of a semiconductor substrate (1);
forming a second electrically conductive film (4) on said first electrically conductive film (3);
forming a first insulating film (5) on said second electrically conductive film (4);
patterning said first insulating film (5) in regions thereof in which posts (4b) for electrically connecting an upper wiring layer to a lower wiring layer are to be formed, by means of photolithography;
forming a first pattern of laminated wiring by etching said second and first electrically conductive films (4; 3)continuously by means of photolithography;
forming said posts (4b) for electrically connecting said lower wiring layer composed of said first electrically conductive film (3) and said upper wiring layer composed of said second electrically conductive film (4) by etching away said second electrically conductive film (4) of said laminated wiring pattern with using said first insulating film pattern (5a) as a mask;
forming a second insulating layer (8) to a thickness larger than a height of said posts (4b);
flattening said second insulating film (8) and exposing surfaces of said posts (4b) by etching back said second insulating film (8);
forming a third electrically conductive film; and forming a second wiring pattern by etching said third electrically conductive film by photolithography.

5. A semiconductor device fabrication method comprising the steps of:
forming a first electrically conductive film (3) on an under-layer insulating film (2) formed on a surface of a semiconductor substrate (1);
forming a second electrically conductive film (4) on said first electrically conductive film (3);
forming a first pattern of laminated wiring by etching said second and first electrically conductive films (4; 3) continuously by means of photolithography;
forming posts (4b) for electrically connecting a lower wiring layer composed of a first electrically conductive film pattern of said laminated wiring and an upper wiring layer composed of a second electrically conductive film pattern of said laminated wiring by etching away said second electrically conductive film (4) of said laminated wiring pattern with using a resist pattern formed by photolithography;
forming an insulating layer (8) to a thickness larger than a height of said posts (4b);
flattening said insulating film (8) and exposing surfaces of said posts (4b) by chemically and mechanically polishing a surface of said insulating film (8);
forming a third electrically conductive film; and
forming a second wiring pattern by etching said third electrically conductive film by photolithography.
